# FASCICULE DE BREVET EUROPEEN

(11) **EP 2 963 812 B1**
(45) Date de publication et mention de la délivrance du brevet: **19.08.2020**
(21) Numéro de dépôt: 15174830.8
(22) Date de dépôt: 01.07.2015
(51) Int. Cl.: H03F 3/189, H03F 3/54, H01J 25/00, H01J 23/34, H04B 7/185

(54) **DISPOSITIF AMPLIFICATEUR À AU MOINS UN TUBE HYPERFRÉQUENCES**
VERSTÄRKERVORRICHTUNG MIT MINDENSTENS EINER HYPERFREQUENZRÖHRE
AMPLIFIER DEVICE WITH AT LEAST ONE MICROWAVE TUBE

(30) Priorité: 04.07.2014 FR 1401508
(43) Date de publication de la demande: 06.01.2016
(73) Titulaire: THALES, 92400 Courbevoie (FR)
(72) Inventeur: BALAYER, Christophe, 31037 TOULOUSE (FR); TRANCART, Bruno, 31037 TOULOUSE (FR)
(74) Mandataire: Brunelli, Gérald

(56) Documents cités:
- JP-A- 2007 273 158
- US-A1- 2002 089 372
- US-B2- 7 131 484

## Description

L'invention porte sur un dispositif amplificateur à au moins un tube hyperfréquences, tel un tube à ondes progressives ou un klystron, notamment pour satellites.

Les aménagements de panneaux de satellites supportant la charge utile sont complexes, notamment du fait du manque de flexibilité des dispositifs amplificateurs à au moins un tube hyperfréquences.

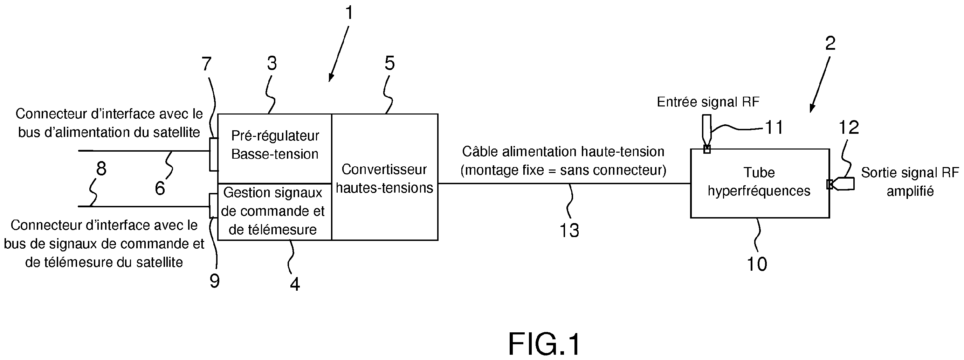

La figure 1 illustre un tel dispositif amplificateur à au moins un tube hyperfréquences, selon l'état de la technique. Voir par exemple la demande de brevet publiée US 2002/0089372 A1.

Un tel dispositif comprend une partie d'alimentation électrique 1 de l'amplificateur RF et une partie d'amplificateur RF 2.

La partie d'alimentation électrique 1 comprend un pré-régulateur 3 à basse tension électrique, un module de gestion 4 de signaux de commande et de télémesure, ainsi qu'un convertisseur 5 en hautes-tensions électriques.

On entend par basse tension électrique une tension électrique inférieure à 200 Volts, et par haute tension électrique une tension électrique supérieure à 200 Volts.

Le pré-régulateur 3 est relié au bus d'alimentation 6 du satellite par un connecteur d'interface 7, et le module de gestion 4 est relié au bus 8 de signaux de commande et de télémesure par un connecteur d'interface 9;

La partie amplificateur RF 2 comprend au moins un tube hyperfréquences 10 muni d'une entrée 11 de signal RF et une sortie 12 de signal RF amplifié. Un câble d'alimentation à haute tension électrique 13 à montage fixe sans connecteur relie la partie d'alimentation électrique 1 de l'amplificateur RF et la partie d'amplificateur RF 2.

Pour intégrer un tel dispositif amplificateur il faut deux à trois personnes car l'installation demande beaucoup de précaution. En outre, un tel dispositif complique le montage de ces éléments sur des panneaux de niveaux physiques différents

Il est nécessaire de définir les longueurs des câbles électriques de haute tension à un stade très en amont de la phase de définition de la charge utile pour des raisons de temps de cycle de fabrication, ce qui interdit l'optimisation de leur longueur et implique une approche pénalisante de leur dimensionnement, car ces câbles sont longs, lourds et difficiles à installer. Il est impossible, après fabrication d'un tel dispositif amplificateur, de l'interchanger avec un autre.

La conception conventionnelle d'un tel dispositif amplificateur utilise un câble à haute tension électrique entraînant des contraintes d'aménagement des équipements sur le panneau de charge utile, une longueur de câble généralement surdimensionnée parce que devant être déterminées très en amont des phases de réalisation.

Aussi, de tels modes de réalisation impliquent des surcoûts et surcroîts de masse de la charge utile globale, ainsi que des problèmes de décalage de planning d'avancement lors de l'étape d'intégration ou de remplacement du dispositif amplificateur.

Un but de l'invention est de pallier les inconvénients précédemment cités.

Aussi, il est proposé, selon un aspect de l'invention, un dispositif amplificateur à au moins un tube hyperfréquences, destiné à être monté sur un satellite, comprenant une section à haute tension électrique directement connectée audit tube ou auxdits tubes hyperfréquences, une section à basse tension électrique, et un ensemble de câblage à basse tension électrique muni de connecteurs basse tension électrique à ses extrémités reliant lesdites sections à basse et haute tensions électriques, ladite section à haute tension électrique étant disposée sur une même plaque de base que le ou les tubes hyperfréquences, selon la première revendication.

Un tel dispositif, dans lequel la partie basse tension et la partie haute tension sont séparées et dans lequel ces deux parties sont reliées par un ensemble de câblage à basse tension électrique muni de connecteurs basse tension électrique à ses extrémités, permet de limiter drastiquement les coûts d'intégration d'un tel dispositif dans un satellite.

En effet, il n'est plus nécessaire d'utiliser des longueurs de câbles surdimensionnées, ni d'avoir deux à trois personnes pour effectuer le montage, ni de faire un choix de câble longtemps à l'avance.

Un tel dispositif permet d'installer la section à haute tension électrique du dispositif d'amplification au plus près ou sur la même plaque de base que le ou les tubes hyperfréquences, ce qui évite le besoin d'interconnexion par câble à haute tension entre les deux sections, de coût élevé et ne permettant pas d'être déconnectable dans l'environnement spatial (isolements délicats).

On entend par plaque de base, une plaque métallique sur laquelle est installée le ou les corps du ou des tubes hyperfréquences et donc le rôle est, d'une part, de permettre un montage mécanique du dispositif sur le panneau d'un satellite dans les règles de l'art ,et d'autre part d'assurer une surface de contact appropriée permettant un échange thermique optimum avec le panneau. Mettre la section à haute tension électrique sur une même plaque de base que le ou les tubes hyperfréquences est possible grâce à l'utilisation de récents composants pouvant opérer à très hautes températures, typiquement des températures supérieures à 110°C.

Dans un mode de réalisation, ledit ensemble de câblage à basse tension électrique comprend au moins un câble d'alimentation électrique à basse tension et un bus de signaux de commande et de télémesure.

Ainsi, un tel câble est facile à réaliser et peut alors être équipé de connecteurs à ses deux extrémités.

Selon un mode de réalisation, ladite section à basse tension électrique comprend un module pré-régulateur de basse tension électrique, et un module de gestion de signaux de commande et de télémesure.

Ainsi, les solutions et technologies utilisées tant en électronique de puissance que pour les circuits de gestion de signaux de télémesure et de télécommande appartiennent à des domaines communs tels que ceux de la basse fréquence et basse tension et peuvent ainsi être regroupées

Dans un mode de réalisation, ladite section à haute tension électrique comprend un module générateur de hautes tensions et un module de traitement de signaux de commande et de télémesure.

Ainsi, le module générateur de hautes tensions nécessite d'être commandé par des signaux de bas niveaux et doit fournir en retour des informations de télémesure. Le codage et/ou décodage de ces signaux par le module de traitement doivent être réalisés au plus près du module générateur de hautes tensions et afin d'avoir des caractéristiques permettant de les transmettre sans distorsion via le câble.

Dans un mode de réalisation, ledit module générateur de hautes tensions électriques de ladite section à haute tension comprend:
- un module convertisseur de basse tension en hautes tensions; et
- un module de redressement de hautes tensions et de filtrage.

Ainsi, les deux fonctions des modules font appel à des technologies de réalisations très différentes et doivent être séparées. En particulier, la section à haute tension électrique nécessite des précautions d'isolation électrique tout à fait particulières dans sa mise en œuvre.

Par exemple, ladite section à haute tension électrique comprend, en outre, un module de commande d'activation/désactivation du tube ou des tubes hyperfréquences.

Ainsi, un tube hyperfréquences nécessite de disposer de nombreuses tensions électriques d'alimentation de ses diverses électrodes différentes et doit être mis en route selon un séquencement tout à fait particulier.

Dans un mode de réalisation, ladite basse tension électrique est inférieure à 200 V.

Ainsi, la section à basse tension a pour fonction de pré-réguler la tension du bus satellite avant même de la convertir sous forme de tensions ultra stables et utilisables par le tube hyperféquences.

Selon un mode de réalisation, ladite haute tension électrique est supérieure à 200 V.

Ces hautes tensions sont nécessaires pour permettre d'atteindre les paramètres de vitesse, de phase et de focalisation du faisceau d'électrons autorisant le mécanisme d'amplification de l'onde hyperfréquences au sein du tube.

Il est également proposé, selon un autre aspect de l'invention, un satellite comprenant un dispositif tel que précédemment décrit.

L'invention sera mieux comprise à l'étude de quelques modes de réalisation décrits à titre d'exemples nullement limitatifs et illustrés par les dessins annexés sur lesquels :
- la figure 1 illustre schématiquement un dispositif amplificateur à au moins un tube hyperfréquences, selon l'état de la technique; et
- les figures 2 à 4 illustrent schématiquement un dispositif amplificateur à au moins un tube hyperfréquences, selon divers aspects de l'invention.

Sur l'ensemble des figures, les éléments ayant des références identiques sont similaires. Dans la présente description, le dispositif est décrit pour être intégré à un satellite, mais de manière non limitative, car un tel dispositif peut être intégré à tout autre système, notamment spatial.

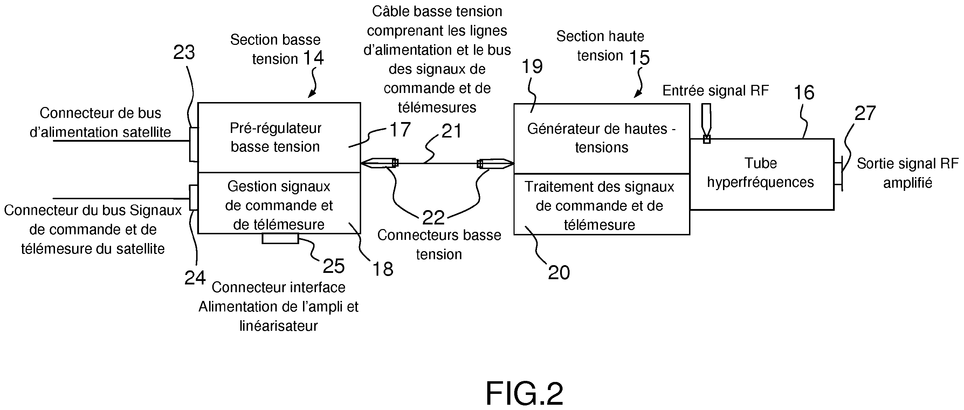

Il est proposé, comme illustré sur la figure 2, un dispositif amplificateur selon un aspect de l'invention.

Le dispositif amplificateur comprend une section à basse tension électrique 14, une section à haute tension électrique 15, et au moins un tube hyperfréquences 16, en l'espèce, de manière non limitative, un seul.

La section à basse tension électrique 14 comprend un module pré-régulateur 17 de basse tension électrique, et un module de gestion 18 de signaux de commande et de télémesure.

La section à haute tension électrique 15 comprend un module générateur 19 de hautes tensions et un module de traitement 20 de signaux de commande et de télémesure.

Un ensemble de câblage 21 à basse tension électrique muni de connecteurs 22 basse tension électrique à ses extrémités relie la section à basse tension électrique 14 et la section à haute tension électrique 15.

La section à basse tension électrique 14 est munie d'un connecteur 23 de bus d'alimentation électrique du satellite pour relier le module pré-régulateur 17 de basse tension électrique au bus d'alimentation électrique du satellite, d'un connecteur 24 de bus de signaux de commande et de télémesure du satellite pour relier le module de gestion 18 de signaux de commande et de télémesure et le bus de signaux de commande et de télémesure du satellite, et d'un connecteur 25 interface d'alimentation d'amplificateur-linéariseur pour relier le module de gestion 18 de signaux de commande et de télémesure et l'amplificateur-linéarisateur.

Le tube hyperfréquences 16 est muni d'une entrée 11 de signal RF et une sortie 12 de signal RF amplifié.

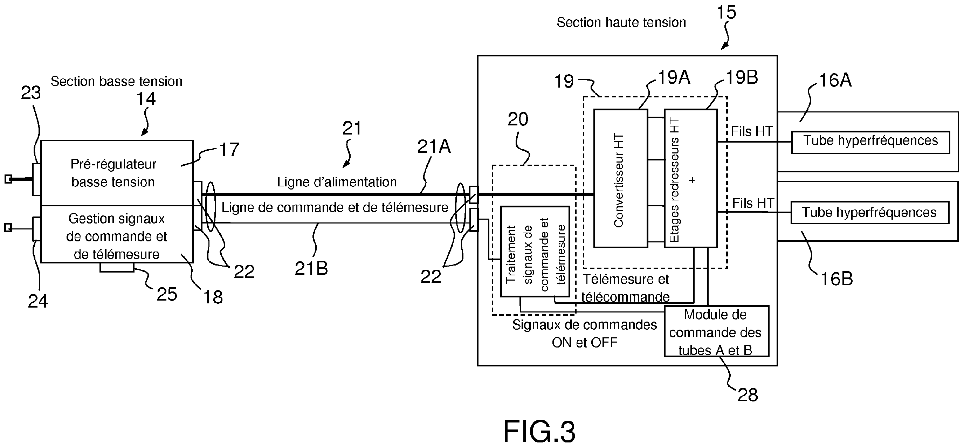

La figure 3 illustre un mode réalisation particulier de la figure 2.

L'ensemble de câblage 21 à basse tension électrique peut comprendre au moins un câble d'alimentation électrique 21A à basse tension et un bus 21B de signaux de commande et de télémesure.

Dans ce mode de réalisation, le module générateur 19 de hautes tensions électriques de la section à haute tension électrique 15 comprend un module convertisseur de basse tension en hautes tensions 19A, et un module 19B de redressement de hautes tensions et de filtrage.

En outre, la section à haute tension électrique 15 comprend, en outre un module 28 de commande d'activation/désactivation du tube ou des tubes hyperfréquences, en l'espèce des deux tubes à hyperfréquences 16A et 16B. Ce module 28 de commande d'activation/désactivation des tubes hyperfréquences 16A et 16B permettent de décoder et mettre en forme des signaux issus du module de gestion 18 via le bus 21B et qui sont dédiés au module de traitement 20 intégré à la section à haute tension électrique 15. Le module de gestion 18 est un dispositif interfaçant directement avec le bus de signaux de télécommande et de télémesure et les identifient afin de les adapter et de les orienter vers les fonctions du module pré-régulateur 17 de la section à basse tension électrique 14 soit vers le module de traitement 20 des signaux de commande et de télémesure de la section à haute tension électrique 15 via le câble 21 intégrant le bus 21B pour ce faire.

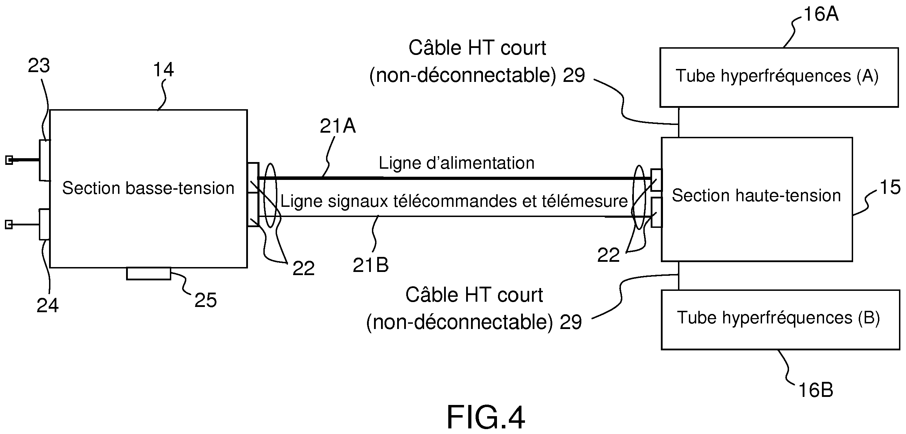

La figure 4 représente schématiquement un mode de réalisation de l'invention dans lequel lesdits tubes hyperfréquences, en l'occurrence les deux tubes hyperfréquences 16A et 16B sont reliés à la section à haute tension électrique 15 par des câbles à haute tension électrique de courte distance 29, i.e une à cinq dizaines de centimètres de longueur bien inférieure à la distance du câble déconnectable 21 ayant pour longueur typique un à cinq mètres.

## Revendications

1. Dispositif amplificateur à au moins un tube hyperfréquences (16, 16A, 16B), destiné à être monté sur un panneau de satellite supportant la charge utile, comprenant une section (15) à haute tension électrique directement connectée audit tube ou auxdits tubes hyperfréquences (16, 16A, 16B), une section (14) à basse tension électrique, et un ensemble de câblage (21, 22) à basse tension électrique muni de connecteurs (22) basse tension électrique à ses extrémités reliant lesdites sections (14, 15) à basse et haute tensions électriques, ladite section (15) à haute tension électrique étant disposée sur une même plaque de base que le ou les tubes hyperfréquences (16, 16A, 16B) de façon à assurer une surface de contact appropriée permettant un échange thermique optimum avec le panneau.

2. Dispositif selon la revendication 1, dans lequel ledit ensemble de câblage (21, 22) à basse tension électrique comprend au moins un câble d'alimentation (21A) électrique à basse tension et un bus (21B) de signaux de commande et de télémesure.

3. Dispositif selon la revendication 1 ou 2, dans lequel ladite section (14) à basse tension électrique comprend un module pré-régulateur (17) de basse tension électrique, et un module de gestion (18) de signaux de commande et de télémesure.

4. Dispositif selon l'une des revendications précédentes, dans lequel ladite section (15) à haute tension électrique comprend un module générateur (19) de hautes tensions électriques et un module (20) de traitement de signaux de commande et de télémesure.

5. Dispositif selon l'une des revendications précédentes, dans lequel ledit module générateur (19) de hautes tensions électriques de ladite section (15) à haute tension comprend:
- un module convertisseur (19A) de basse tension en hautes tensions; et
- un module (19B) de redressement de hautes tensions et de filtrage.

6. Dispositif selon la revendication 5, dans lequel ladite section (15) à haute tension électrique comprend, en outre, un module de commande (28) d'activation/désactivation du tube ou des tubes hyperfréquences.

7. Dispositif selon l'une des revendications précédentes, dans lequel ladite basse tension électrique est inférieure à 200 V.

8. Dispositif selon l'une des revendications précédentes, dans lequel ladite haute tension électrique est supérieure à 200 V.

9. Satellite comprenant un dispositif selon l'une des revendications précédentes.

## Patentansprüche

1. Verstärkervorrichtung mit mindestens einer Hyperfrequenzröhre (16, 16A, 16B), bestimmt zur Montage auf einem Satellitenpaneel, welches die Nutzlast stützt, beinhaltend einen Abschnitt (15) mit elektrischer Hochspannung, welcher direkt mit der oder den Hyperfrequenzröhre(n) (16, 16A, 16B) verbunden ist, einen Abschnitt (14) mit elektrischer Niedrigspannung und einen Verdrahtungssatz (21, 22) mit elektrischer Niedrigspannung, versehen mit Verbindern (22) mit elektrischer Niedrigspannung an seinen Enden, welche die Abschnitte (14, 15) mit elektrischer Niedrigspannung und Hochspannung verbinden, wobei der Abschnitt (15) mit elektrischer Hochspannung auf einer selben Grundplatte wie die Hyperfrequenzröhre(n) (16, 16A, 16B) in einer Weise angeordnet ist, dass er eine geeignete Kontaktfläche gewährleistet, welche einen optimalen Wärmetausch mit dem Paneel ermöglicht.

2. Vorrichtung nach Anspruch 1, bei welchem der Verdrahtungssatz (21, 22) mit elektrischer Niedrigspannung mindestens ein elektrisches Speisekabel (21A) mit Niedrigspannung und einen Bus (21B) für Steuer- und Fernmessungssignale beinhaltet.

3. Vorrichtung nach Anspruch 1 oder 2, bei welcher der Abschnitt (14) mit elektrischer Niedrigspannung ein Vorregelmodul (17) mit elektrischer Niedrigspannung und ein Verwaltungsmodul (18) für Steuer- und Fernmessungssignale beinhaltet.

4. Vorrichtung nach einem der vorhergehenden Ansprüche, bei welcher der Abschnitt (15) mit elektrischer Hochspannung ein Erzeugungsmodul (19) für elektrische Hochspannungen und ein Modul (20) zur Verarbeitung von Steuer- und Fernmessungssignalen beinhaltet.

5. Vorrichtung nach einem der vorhergehenden Ansprüche, bei welcher das Erzeugungsmodul (19) für elektrische Hochspannungen des Abschnittes (15) mit Hochspannung Folgendes beinhaltet:
- ein Umwandlungsmodul (19A) von Niedrigspannung auf Hochspannungen; und
- ein Modul (19B) zum Gleichrichten von Hochspannungen und zum Filtern.

6. Vorrichtung nach Anspruch 5, bei welcher der Abschnitt (15) mit elektrischer Hochspannung zudem ein Steuermodul (28) zum Aktivieren/Deaktivieren der Hyperfrequenzröhre(n) beinhaltet.

7. Vorrichtung nach einem der vorhergehenden Ansprüche, bei welchem die elektrische Niedrigspannung unter 200 V beträgt.

8. Vorrichtung nach einem der vorhergehenden Ansprüche, bei welchem die elektrische Hochspannung über 200 V beträgt.

9. Satellit, welcher eine Vorrichtung nach einem der vorhergehenden Ansprüche beinhaltet.

## Claims

1. An amplifier device with at least one microwave tube (16, 16A, 16B), intended to be mounted on a satellite panel supporting the payload, including a high electrical voltage section (15) directly connected to said microwave tube or tubes (16, 16A, 16B), a low electrical voltage section (14), and a low electrical voltage cabling assembly (21, 22) provided with low electrical voltage connectors (22) at the ends thereof connecting said low and high voltage sections (14, 15), said high voltage section (15) being arranged on the same base plate as the microwave tube or tubes (16, 16A, 16B) so as to ensure an appropriate contact surface allowing optimum heat exchange with the panel.

2. The device according to claim 1, wherein said low electrical voltage wiring assembly (21, 22) comprises at least one low electrical voltage power supply cable (21A) and a control and telemetry signal bus (21B).

3. The device according to claim 1 or 2, wherein said low electric voltage section (14) includes a low electric voltage pre-regulator module (17), and a control and telemetry signal management module (18).

4. The device according to one of the preceding claims, wherein said high electric voltage section (15) includes a high electric voltages generator module (19) and a control and telemetry signal processing module (20).

5. The device according to one of the preceding claims, wherein said high electric voltage generator module (19) of said high voltage section (15) includes:
- a low voltage to high voltage converter module (19A); and
- a high voltage rectifier and filter module (19B).

6. The device according to claim 5, wherein said high electric voltage section (15) further comprises a control module (28) for activating/deactivating the microwave tube or tubes.

7. The device according to one of the preceding claims, wherein said low electric voltage is less than 200 V.

8. The device according to one of the preceding claims, wherein said high electrical voltage is more than 200 V.

9. A satellite including a device according to one of the preceding claims.
